# EUROPEAN PATENT APPLICATION

(11) **EP 2 244 315 A1**
(43) Date of publication of application: **27.10.2010**
(21) Application number: 09158508.3
(22) Date of filing: 22.04.2009
(51) Int. Cl.: H01L 51/00

(54) **Method of manufacturing an organic light emitting diode (OLED)**

(71) Applicant: Nederlandse Organisatie voor Toegepast -Natuurwetenschappelijk Onderzoek TNO, 2628 VK Delft (NL)
(72) Inventor: Kruijt, Peter G.M., 5642 RL Eindhoven (NL)
(74) Representative: Hatzmann, Martin

(57) **Abstract**

The invention relates to method of manufacturing an organic light emitting diode (OLED) comprising the steps of: selecting a pre-manufactured substrate (20a) comprising a substrate layer, a barrier layer and anode layer and an insulator layer (8); depositing a number of drops (14, 15) of a reagent on the insulator layer for at least partially dissolving a material of the insulator layer or for chemically interacting with the material of the insulator layer for forming respective electrically conductive paths between the anode layer and a material of the reagent.

## Description

### FIELD

The invention relates to a method of manufacturing an organic light emitting diode (OLED).

### BACKGROUND

An embodiment of the method as is set forth in the opening paragraph is known from GB 2 429 594. The known method comprises the steps of depositing of an anode layer on a suitable substrate, followed by deposition of an injection layer, such as a PEDOT layer, after which a semiconductor layer and an organic insulator layer are deposited. In order to suitably pattern the insulator layer a series of droplets of a solvent are applied thereon. Chemical composition of the solvent is selected so that the organic insulator is cratered. The solvent is deposited at pre-determined regions which correspond to a desired patterning of the insulator layer. After the craters in the insulator layer are formed, the craters are filled with a further semiconductor, which act as a light emitting layer. Deposition of the light emitting semiconductor is carried out with the same patterning as deposition of the solvent, as the semiconductor is conceived to be present solely in the craters. A layer of cathode may then be applied on top of the resulting structure.

It is a disadvantage of the known method that spatial matching has to be performed between the envisaged pattern of the craters, the pattern of the deposited droplets of solvent and the pattern of the light emitting material, which has to be solely present in the craters of the insulator layer formed by the solvent. It is a further disadvantage of the known method that electrical conductivity between the anode layer and the cathode layer may be affected by a spatial alignment between the achieved patterns. It is a further disadvantage of the known method that a relatively expensive PEDOT material is applied along the whole cross-section of the substrate. As a result the manufacturing costs of an OLED of the prior art are unnecessarily increased.

A further embodiment of the method as is set forth in the opening paragraph is known from US 2002/0197754. In the known method an OLED is provided by spatially overlapping a number of patterned anode electrodes separated by an insulating layer from a number of patterned cathode electrodes, wherein a layer of an electrically conducting light emissive material is provided along substantially entire cross-section of a substrate accommodating the anode electrodes and the cathode electrodes. In the known method the light emitting material comprises active components, such as organic molecules of poly(phenylene vinylene) which emit light upon a suitable electrical stimulation. For purposes of providing electrical path between the layer of the electrically conductive light emitting material and the anode electrodes or the cathode electrodes a number of apertures is provided in the layer of the light emitting material, wherein each aperture communicates with either the anode or the cathode. The OLED is thus divided into a matrix of addressable light emitting picture elements.

It is a disadvantage of the known method that operational characteristics of the resulting OLED is strongly dependent on spatial alignment between the stripes of the electrodes and the apertures provided in the electrically conductive light emitting layer. In addition, the known method uses excessive amount of the conductive light emitting material, which is an expensive material, thereby unnecessarily increasing production costs.

A still further embodiment of the method as is set forth in the opening paragraph, is known from US 2005/0048228. In the known method a layer of conducting polymer (PEDOT) is applied over the whole cross-section of a substrate comprising due structures for forming an OLED. The known method further comprises a step of applying a conductivity enhancing agent deposited from a printing solution. The conductivity enhancing agent is conceived to decrease resistivity of the layer of conductive polymer at least by a factor of 10 below 1 x 10⁶ Ohm.

It is a disadvantage of the known method that a layer of the conductive polymer is applied substantially over the whole cross-section of the substrate. Therefore, when for the conductive polymer expensive materials are used, such as PEDOT, the known method is expensive, as excessive amounts of the conductive polymer are deposited on the substrate.

A still further embodiment of the method as is set forth in the opening paragraph is known from US 2006/00228906. In the known method a substrate is provided with a continuous layer of a conductive polymer, such as PEDOT, which is subsequently patterned using a particle beam applied via a mask, so that electrical conductivity of the polymer layer is decreased at areas irradiated with the particle beam. The resulting irradiated areas act as insulator islands electrically isolating an anode layer located underneath the polymer layer from the light emitting layer and a cathode layer deposited on the polymer layer.

It is a disadvantage of the known method that the electrically conductive PEDOT layer is applied substantially along the whole cross-section of the substrate. In addition, it is a disadvantage of the known method that the resulting patterning accuracy of the polymer layer may be reduced due to beam divergence on the mask used for irradiation.

A still further embodiment of the method as is set forth in the opening paragraph is known from WO 02/082561. In the known method a substrate comprising a layer of anode is covered by an insulator layer which is subsequently patterned using droplets formed by an active material dissolved in a solvent. For example, a first, insulating, polymer material may be selected for the insulator layer. In this case the droplet may be formed by a second polymer, for example a light emitting polymer (LEP), dissolved in a solvent capable of dissolving the first polymer material. The first, insulating, polymer is in contact with the anode and the second, light emitting, polymer is in contact with the cathode. Preferably, a PEDOT layer is arranged between the anode layer and the insulating polymer layer.

In order to provide electrical connectivity between the anode layer and the cathode layer, the first insulated polymer is etched by the droplet comprising LEP and the solvent. As a result of chemical interaction between the solvent and the insulating polymer, the resulting solution will contain the insulating polymer and LEP. In accordance with technologic requirements of the known method the insulating polymer and LEP should be selected so that phase separation occurs between the two polymers when the solution drop of the mixture dries and turns into a solid film.

It will be appreciated that surface interaction between the drop and the insulating polymer will define the resulting configuration of the pattern of phase separation between the polymers in the dried condition. For example, the phase separation pattern may comprise interchanging layers when viewed along a cross-section of the resulting structure. Alternatively, the resulting pattern may have a banking structure wherein the insulating polymer is shaped into a crater homogeneously filled with LEP. Still alternatively, the resulting pattern may have a substantially homogeneous LEP region wherein spheres of the insulating (i.e. dissolved) polymer are present.

It is a disadvantage of the known method that a great variety of patterns may be formed in the areas affected by the solvent drop leading to a diversity of resulting local electric resistances of the thus formed connectivity path. It is a still further disadvantage of the known method that a continuous PEDOT layer is applied between the anode layer and the insulating polymer layer, increasing production costs.

### SUMMARY OF THE INVENTION

It is an object of the invention to provide a method of manufacturing an organic light emitting diode (OLED), which is more reliable and/or more cost-effective than methods known from the prior art.

To this end, method of manufacturing an organic light emitting diode (OLED) comprising the steps of:
- selecting a pre-manufactured substrate comprising a substrate layer, a barrier layer and anode layer and an insulator layer;
- depositing a number of drops of a reagent on the insulator layer for at least partially dissolving a material of the insulator layer or for chemically interacting with the material of the insulator layer for forming respective electrically conductive paths between the anode layer and a material of the reagent.

It is found that electrical connectivity between the anode layer and the cathode layer may be substantially improved when electrically connecting paths are provided by accurately depositing droplets of a reagent conceived to react with a material of the insulator layer for converting it into a semiconductor or a conductor. In particular, it is found that when making OLEDs for signage applications, the image to be shown can vary from print to print. If the number of masks needs to be reduced as much as possible, it is desirable to provide a standard substrate that can be patterned using conventional means, for example using ink-jet printing. Such a standard substrate could comprise a carrier foil (e.g. PEN or PET), a barrier layer and an anode. On top of the anode a conductive polymer and a light emitting polymer may be deposited in places where these materials are required. As a result electrical shortcuts pursuant to misalignment problems known from the prior art may be mitigated.

In an embodiment of the method according to the invention for the reagent poly(3,4-ethylenedioxythiophene) (PEDOT) is selected, wherein the material of the insulator layer comprises a polysaccharide.

It is found that when for the insulator material a polysaccharide layer is used, the PEDOT material acts as a solvent for the polysaccharide layer. As a result resistivity of the insulator layer is decreased locally by letting the PEDOT material to locally solve the insulator layer and to locally at least partially substitute the insulator material. As a result semi-conductive or conductive paths may be created in the insulator layer thereby providing connectivity paths between the anode layer via the PEDOT material and the LEP material towards the cathode layer. This has an effect that production costs of such OLED is substantially decreased as expensive PEDOT and LEP materials are applied locally, i.e. where connectivity to the anode layer is to be provided.

In a further embodiment of the method according to the invention the pre-manufactured substrate further comprises a layer of poly(3,4-ethylenedioxythiophene) (PEDOT) arranged between the anode layer and the insulator layer, wherein for the reagent a light emitting polymer (LEP) material is selected.

In addition, using an insulator layer that dissolves or reacts with PEDOT and forms at least a partially conductive path ensures that no shorts will occur between the anode layer and the cathode layer. Still additionally, an amount of ink required to create the image may be substantially reduced as ink is applied at pre-determined positions, i.e. wherein electrical connectivity is required. More additionally, in the embodiment of the invention the insulator layer is not required to be printed, but can be readily applied on a half-fabricate of the substrate comprising the anode layer. Wetting properties of the insulator layer may be tuned for improving layer formation properties of the insulator itself or of a further material conceived to be applied on the insulator layer. This feature further simplifies the method of OLED manufacturing.

It will be appreciated that next to PEDOT, PEDOT-like liquids may be used, for example, PEDOP (poly-(3,4-(ethylenedioxy)pyrrole)), as they have suitable reagent properties for at least partially dissolving a material of the insulator layer or for chemically interacting with the material of the insulator layer for forming respective electrically conductive paths between the anode layer and a material of the reagent. It is also possible that for the reagent a pentacene precursor ink or the like is used.

Such arrangement provides an alternative for saving expensive materials during manufacturing of an OLED structure. It will be appreciated that light emitting polymers, like conductive polymers, are expensive materials and by minimizing their application per print overall production costs may be decreased.

In accordance with the present embodiment another standard substrate is provided, comprising a substrate foil, an anode layer, PEDOT layer, insulator, wherein LEP material is to be applied locally for providing electrical paths between the anode layer towards a cathode layer which will be deposited later. When the LEP is applied, it dissolves or reacts with the insulating layer and thus forms a conductive path, which runs via PEDOT towards pre-determined positions on the anode layer.

In this embodiment both PEDOT and insulator may be deposited in a non-patterned way, which may be advantageous as no alignment between these layers is required.

In a still further embodiment of the method according to the invention the anode layer comprises poly(3,4-ethylenedioxythiophene) (PEDOT), wherein for the reagent a light emitting polymer (LEP) material is selected.

It is found that it is possible that the anode layer and the PEDOT layer are one and the same layer. This embodiment has an advantage that a number of layers to be deposited on the substrate is reduced.

These and other aspects of the invention will be discussed in more detail with reference to drawings, wherein like reference numerals refer to like elements. It will be appreciated that the drawings are presents for illustrative purposes and may not be used for limiting the scope of the appended claims.

### BRIEF DESCRIPTION OF THE DRAWINGS

Figure 1 presents in a schematic way an embodiment of a standard substrate layout, which may be used in the method according to the invention.
Figure 2 present in a schematic way an embodiment of the method of the invention.
Figure 3 presents in a schematic way an embodiment of an OLED manufactured in accordance with the method of the invention.

### DETAILED DESCRIPTION OF THE DRAWINGS

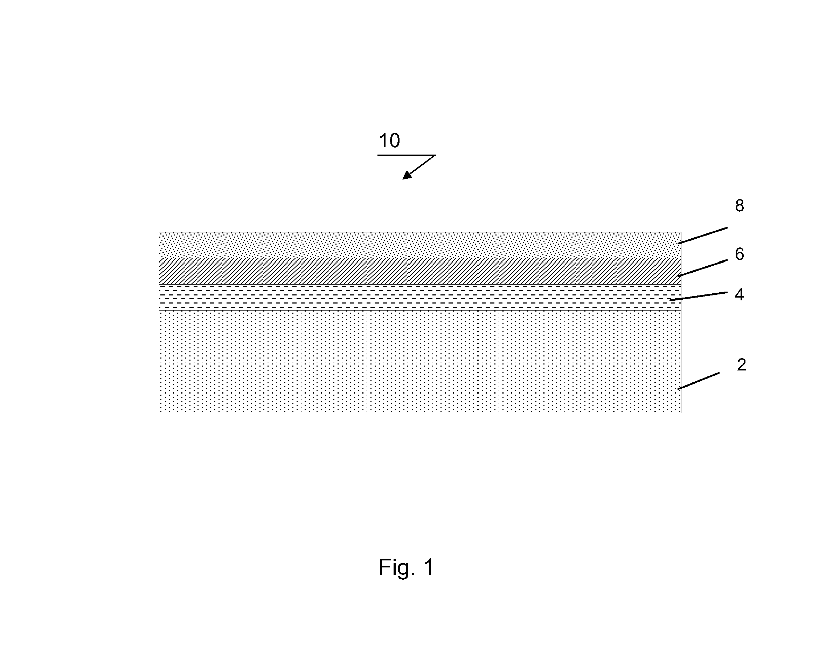

Figure 1 presents in a schematic way an embodiment of a standard substrate layout, which may be used in the method according to the invention. The standard substrate 10 may comprise a carrier layer 2, made, for example, from PEN or PET material. A barrier layer 4, comprising a suitable material, like glass, silicon oxide, or silicon nitrite can be deposited on the carrier foil 2. On top of the barrier layer 4 an anode layer 6 is deposited, followed by an insulator layer 8. It will be appreciated that the anode layer 6 may be patterned or may be applied over the whole cross-section of the carrier foil 2. It will further be appreciated that a material of the insulator layer should be selected in such a way that this material undergoes a desired interaction with a reagent used for creating conductive paths. For example, when for the reagent PEDOT is selected, the insulator layer may comprise a polysaccharide, which is soluble in PEDOT.

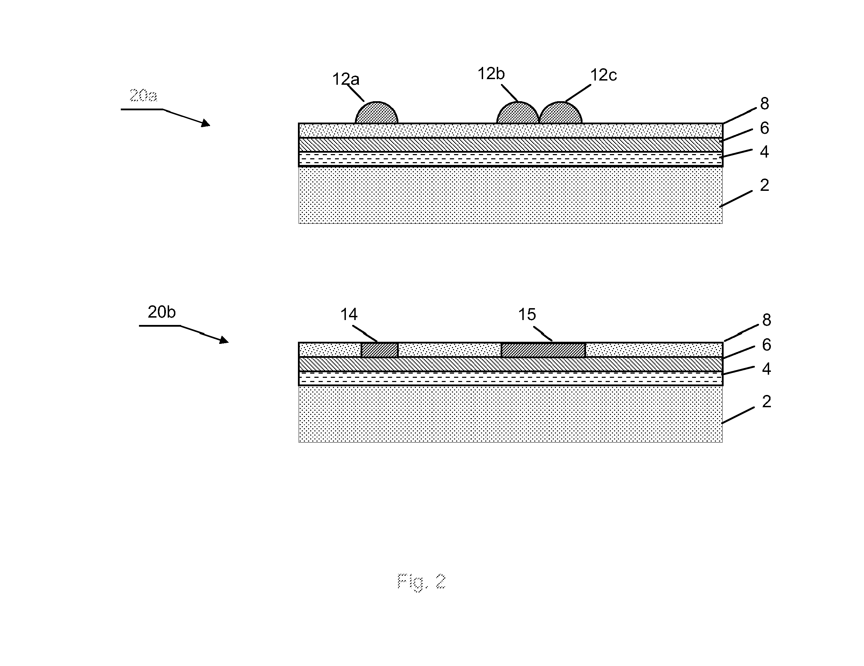

Figure 2 present in a schematic way an embodiment of the method of the invention. In accordance with the method of the invention a standard substrate 20a, comprising layers, as is discussed with reference to Figure 1, is selected. On top of the insulator layer 8, which in this case may comprise a polysaccharide layer, droplets of PEDOT are applied in suitable configuration. It will be appreciated that one or more droplets per location may be applied in dependence on a desired absolute dimension of a conductive path arranged in the insulator material 8 by PEDOT. For example, when a minor area is to be provided, like item 14, schematically depicted in view 20b, a single drop of PEDOT may be sufficient. In case when a larger conductive area is desired, like item 15, shown in view 20b, two or more droplets of PEDOT may be applied. Preferably, the droplets of PEDOT are deposited using ink-jet printing. It will be appreciated that that an absolute dimension of a single droplet may vary between 10 and 60 micrometers. However, it is also possible to use droplets of 1 to 100 picoliter, as well as droplets in the femtoliter range. A corresponding thus created conductive area may be in the range of 15 to 300 micrometers (per drop).

It is found that OLEDs manufactured in accordance with the method of the invention may have superior operational characteristics as mobility of the printed droplets in a corresponding layer will be lower than in the prior art, leading to better long-term localization of the conductive area. As a suitable droplet, for example a PEDOT droplet falls on the substrate, it may only spread on the substrate as it is usually impregnable. However, in the method according to the invention the droplet does not only spread itself on the surface of the substrate, but it also permeates in the conductive layer, reacting with it, or dissolving it. The droplet spreads therefore as it were in three dimensions instead of two dimensions as in the prior art. Due to the volume conservation lateral spreading of the drop on the substrate will be decreased.

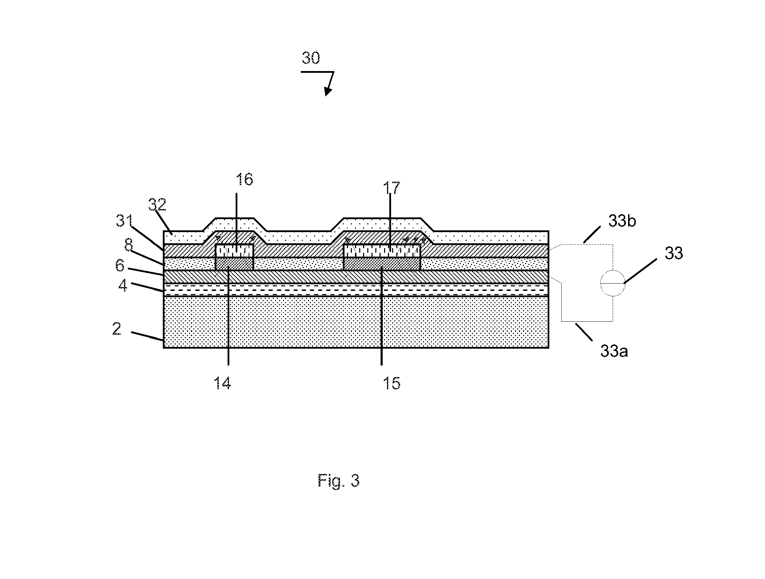

Figure 3 presents in a schematic way an embodiment of an OLED 30 manufactured in accordance with the method of the invention. The OLED structure 30 comprises a carrier foil 2, a barrier layer 4, an anode layer 4 an insulator layer 6 provided with conductive paths 14, 15 using PEDOT, as is described with reference to Figure 2. On top of the insulator layer, at areas corresponding to conductive paths 14, 16 a suitable light emitting polymer (LEP) is deposited. Preferably LEP is deposited using ink-jet printing having the same deposition pattern as a pattern used for depositing PEDOT. On top of LEP a cathode layer 31 is provided. It will be appreciated that in the present embodiment both PEDOT and LEP material are saved, as they are deposited in the print locally, only at areas wherein conductivity and light emission is required. Finally, the OLED structure may comprise a further barrier layer 32 for covering the cathode layer. In order to enable OLED functionality, the structure 30 is connected to a suitable electrical source 33 having a first contact 33a arranged on the anode layer 6 and a second contact 33b arranged on the cathode layer 31.

It will be appreciated that while specific embodiments of the invention have been described above, that the invention may be practiced otherwise than as described. In addition, isolated features discussed with reference to different figures may be combined. In particular, it will be appreciated that the electronic structure according to the invention may be applicable to any device having a multilayered structure, wherein individual layers are connected by electrically conductive paths.

## Claims

1. A method of manufacturing an organic light emitting diode (OLED) comprising the steps of:
- selecting a pre-manufactured substrate comprising a substrate layer, a barrier layer and anode layer and an insulator layer;
- depositing a number of drops of a reagent on the insulator layer for at least partially dissolving a material of the insulator layer or for chemically interacting with the material of the insulator layer for forming respective electrically conductive paths between the anode layer and a material of the reagent.

2. A method according to claim 1, wherein for the reagent poly(3,4-ethylenedioxythiophene) (PEDOT) is selected, wherein the material of the insulator layer comprises a polysaccharide.

3. A method according to claim 1, wherein for the reagent a pentacene precursor ink is used.

4. A method according to claim 1, wherein the pre-manufactured substrate further comprises a layer of poly(3,4-ethylenedioxythiophene) (PEDOT) arranged between the anode layer and the insulator layer, wherein for the reagent a light emitting polymer (LEP) material is selected.

5. A method according to claim 1, wherein the anode layer comprises poly(3,4-ethylenedioxythiophene) (PEDOT), wherein for the reagent a light emitting polymer (LEP) material is selected.

6. A method according to any one of the preceding claims, wherein droplets of the reagent are deposited using a technique selectable from a group consisting of ink-jet printing, gravure printing, flexo printing, or screen printing.
